# EUROPÄISCHE PATENTSCHRIFT

(11) **EP 3 637 116 B1**
(45) Veröffentlichungstag und Bekanntmachung des Hinweises auf die Patenterteilung: **14.08.2024**
(21) Anmeldenummer: 19201087.4
(22) Anmeldetag: 02.10.2019
(51) Int. Cl.: G01R 31/00, G01R 31/28, G01R 35/00

(54) **SENSOR UND VERFAHREN ZUR ÜBERPRÜFUNG EINES SENSORS**
SENSOR AND METHOD FOR VERIFYING SAME
DÉTECTEUR ET PROCÉDÉ DE VÉRIFICATION D'UN DÉTECTEUR

(30) Priorität: 12.10.2018 DE 102018217532
(43) Veröffentlichungstag der Anmeldung: 15.04.2020
(73) Patentinhaber: Continental Automotive Technologies GmbH, 30175 Hannover (DE)
(72) Erfinder: Schramme, Martin, 60488 Frankfurt am Main (DE)
(74) Vertreter: Continental Corporation

(56) Entgegenhaltungen:
- EP-A1- 2 623 996
- EP-A2- 1 906 192
- DE-A1- 10 142 169
- DE-A1- 102005 035 409
- DE-A1- 102007 020 760
- DE-A1- 102009 020 431
- DE-A1- 102014 219 806
- US-A- 5 754 963
- US-A1- 2007 287 924

## Beschreibung

Die Erfindung betrifft einen Sensor, insbesondere einen Batteriesensor zur Bestimmung eines Batteriezustandes einer Batterie, insbesondere einer Fahrzeugbatterie, mit zumindest zwei, jeweils zur Erfassung von mindestens einem Messparameter, insbesondere eines Batterieparameters, und zur Ausgabe eines Messsignals ausgebildeten Messeinrichtungen. Die Erfindung betrifft des Weiteren ein Verfahren zur Überprüfung eines solchen Sensors.

Aus dem Stand der Technik sind Batteriesensoren zur Erfassung des Zustandes einer Fahrzeugbatterie bekannt. Diese Batteriesensoren erfassen permanent die Batteriespannung, den Laststrom sowie weitere Batterieparameter, beispielsweise die Temperatur der Batterie. Der Batteriesensor hat die Aufgabe, die vorstehend genannten Parameter möglichst konstant zu messen, um beispielsweise Informationen über den Ladungszustand oder den Gesundheitszustand der Batterie zu erhalten, und ein Batteriezustandssignal an eine übergeordnete Kontrolleinheit auszugeben. Der Laststrom wird beispielsweise über den Spannungsabfall über einen im Laststrompfad angeordneten Messwiderstand ermittelt.

Die derzeit bekannten Batteriesensoren weisen einen integrierten Schaltkreis auf, der drei Messpfade mit jeweils einem Eingang enthält. Der erste dieser drei Messpfade dient der Bestimmung des Laststroms über den Spannungsabfall über den Messwiderstand. Der zweite Messpfad dient der Messung der Batteriespannung zwischen dem Plus- und dem Minuspol der Batterie. Der dritte Messpfad wird zur Temperaturerfassung genutzt, wobei wechselweise verschiedene Temperatursensoren an den dritten Eingang angeschlossen werden können.

Zur Diagnose bzw. zur Überprüfung der Funktion solcher Batteriesensoren besteht die Möglichkeit, an einen der Eingänge ein Referenzsignal anzulegen und das erhaltene Ausgangssignal mit dem für das Referenzsignal zu erwartenden Signal zu vergleichen. Auf diese Weise kann die Funktion der einzelnen Messpfade überprüft werden.

Alternativ kann der Batteriesensor eine interne Stromquelle aufweisen und zur Überprüfung eines über den Messwiderstand geschlossenen Stromkreises wird ein Strom zwischen den Eingängen des Batteriesensors angelegt.

Diese Methoden zur Überprüfung des Batteriesensors erfordern aber jeweils eine Unterbrechung der Strom- und/oder der Spannungsmessung für die Dauer der Diagnose.

Alternativ ist bekannt, den dritten Messpfad, an dem die Temperatur ermittelt wird, zeitweise zur Messung der Batteriespannung zu verwenden. Da sich die Batterietemperatur im Vergleich zu Batteriespannung oder dem Batteriestrom nur langsam ändert, ist es nicht erforderlich, die Temperaturmessung mit der gleichen Frequenz wie die Spannung- oder die Strommessung durchzuführen. Insbesondere ist es möglich, aufgrund der langsamen Temperaturänderung, die Temperaturmessungen kurzzeitig zu unterbrechen.

EP623996A1 offenbart eine Strommessschaltung, die eine Sensorbaugruppe zur Messung eines durch einen Leiter fließenden elektrischen Stroms mittels Messung einer Eingangsspannung zwischen einer ersten und einer zweiten Eingangsleitung der Sensorbaugruppe und eine Sensorsteuerung zur Steuerung der Sensorbaugruppe umfasst.

Aufgabe der Erfindung ist es, einen Sensor, insbesondere einen Batteriesensor zur Bestimmung eines Batteriezustandes einer Batterie, bereitzustellen, der eine konstante Strom- und Spannungsmessung auch während einer Diagnose des Batteriesensors sicherstellt. Aufgabe der Erfindung ist es des Weiteren ein Verfahren zur Überprüfung eines solchen Sensors bereitzustellen.

Zur Lösung der Aufgabe ist ein Sensor vorgesehen, insbesondere Batteriesensor zur Bestimmung eines Batteriezustandes einer Batterie, insbesondere einer Fahrzeugbatterie. Der Sensor hat zumindest zwei, jeweils zur Erfassung von Messparametern, insbesondere von Batterieparametern, und zur Ausgabe eines Messsignals ausgebildeten Messeinrichtungen, eine Kombinationsschaltung, die aus zumindest einem Messsignal und einem Prüfsignal ein Kombinationssignal bilden kann, ein Auswertemodul, das mehrere Eingänge für Messsignale und/oder das Kombinationssignal, einen Ausgang für ein Kontrollsignal sowie einer Auswerteschaltung zur Ermittlung des Kontrollsignals aus den Messsignalen und dem Kombinationssignal aufweist, und eine Diagnoseschaltung, zum Abgleich des Kontrollsignals mit dem Prüfsignal und zur Ausgabe eines Fehlersignals, wenn eine definierte Abweichung des Kontrollsignals und des Prüfsignals festgestellt wird.

Erfindungsgemäß wird vorgeschlagen, dass die Diagnose des Batteriesensors bzw. des Auswertemoduls nicht im Auswertemodul erfolgt, sondern durch eine vom Auswertemodul unabhängige Diagnoseschaltung. Hierbei ist vorgesehen, dass aus zumindest einem Messsignal sowie einem Prüfsignal ein Kombinationssignal gebildet wird, aus dem durch die Auswerteschaltung das Kontrollsignal ermittelt wird. Durch Vergleich des Prüfsignals und des Kontrollsignals kann eine fehlerhafte Funktion des Auswertemoduls erkannt werden.

Beispielsweise kann das ursprüngliche Prüfsignal durch die Auswerteeinheit aus dem Kombinationssignal herausgefiltert werden. Dies ist möglich, da zur Ermittlung des Kombinationssignals Messsignale verwendet werden, die der Auswerteeinheit ebenfalls bereitgestellt werden. Es sind also keine zusätzlichen Signalübertragungen zwischen dem Kombinationsmodul und dem Auswertemodul erforderlich.

Da für die Ermittlung des Kombinationssignals die Messsignale verwendet werden und weiterhin die Messesignale auch über die übrigen Eingänge des Auswertemoduls empfangen werden, ist des Weiteren über die übrigen Eingänge eine unterbrechungsfreie Erfassung von Messparametern möglich.

Bei den aus dem Stand der Technik bekannten Batteriesensoren wird das Auswertemodul zur Diagnose des Batteriesensors verwendet. Bei dem erfindungsgemäßen Batteriesensor stellt das Auswertemodul bzw. die Auswerteschaltung lediglich ein Kontrollsignal bereit, das von einer weiteren Einrichtung, der Diagnoseschaltung, geprüft wird. Dadurch entsteht ein geschlossener Rückkopplungskreis, so dass auch bei einem Ausfall mehrerer Schaltkreise oder beim Defekt von Komponenten im Auswertemodul oder in der Auswerteschaltung, die von allen Messpfaden gemeinsam genutzt werden, eine Fehlererkennung möglich ist, da die Diagnose des Batteriesensors bzw. des Auswertemoduls durch eine von der Auswerteschaltung abhängige Diagnoseschaltung erfolgt.

Das Kontrollsignal sowie das Prüfsignal können hierbei digitale oder analoge Signale sein. Des Weiteren können die Messsignale ebenfalls analog oder digitale Signale sein. Sind die Signale analog, weist das Auswertemodul vorzugsweise Analog-Digital-Wandler auf, um die analogen Signale zu digitalisieren.

Das Kombinationssignal kann aus mehreren Messsignalen und/oder mehreren Prüfsignalen ermittelt werden. Es ist lediglich erforderlich, dass das Prüfsignal oder die Prüfsignale aus dem Kontrollsignal herausgefiltert werden können.

Die Messesignale sowie die Prüfsignale können auf beliebige Weise miteinander kombiniert werden, vorzugsweise durch mathematische Operationen. Beispielsweise können die Signale addiert werden, wobei die einzelnen Signale vorab verstärkt, herunter geteilt oder anderweitig verarbeitet werden können. Insbesondere sollten die Signale nach der Verarbeitung im Wesentlichen die gleiche Signalstärke aufweisen. Es ist lediglich erforderlich, dass aus dem resultierenden Kombinationssignal im Auswertemodul bzw. in der Auswerteschaltung ein Kontrollsignal ermittelt werden kann, das einen Abgleich mit dem ursprünglichen Prüfsignal ermöglicht.

Ein Eingang des Auswertemoduls kann beispielsweise einen Umschalter aufweisen, um den Eingang wechselweise mit zumindest einer Messeinrichtung oder der Kombinationsschaltung zu verbinden. Der Eingang kann in dieser Ausführungsform wechselweise zur Erfassung eines Messsignals, also beispielsweise eines Batterieparameters, und zur Erfassung des Kombinationssignals verwendet werden.

Beispielsweise ist eine Steuerung zum Wechsel zwischen einem Diagnosemodus und einem Messmodus vorgesehen. Im Diagnosemodus ist erste Eingang mit der Kombinationsschaltung verbunden und empfängt das Kontrollsignal des Auswertemoduls. Im Messmodus ermittelt das Auswertemodul aus den Messsignalen ein Batteriezustandssignal und gibt dieses am Ausgang aus. Der Sensor kann also wechselweise in einem reinen Messmodus, in dem lediglich Messsignale empfangen und verarbeitet werden, und einem Diagnosemodus, in dem neben dem Empfang und der Verarbeitung von Messsignalen auch eine Diagnose des Sensors erfolgt, umgeschaltet werden.

Im Messmodus kann eine Messeinrichtung mit dem ersten Eingang verbunden sein.

Das Auswertemodul weist vorzugsweise drei Eingänge auf, wobei ein erster Eingang mit einer ersten Messeinrichtung, ein zweiter Eingang mit einer zweiten Messeinrichtung und ein dritter Eingang mit dem Umschalter verbunden ist. Die heute verwendeten Batteriesensoren weisen lediglich drei Eingänge auf. Es ist also zur Implementierung des vorstehend beschriebenen Aufbaus nicht erforderlich, zusätzliche Eingänge an dem Batteriesensor vorzusehen.

Vorzugsweise weist jeder Eingang einen Analog-Digital-Wandler auf. Da nur drei Eingänge zum Betrieb und zur Diagnose des Batteriesensors erforderlich sind, ist es nicht erforderlich, zusätzliche Analog-Digital-Wandler für zusätzliche Signaleingänge vorzusehen.

Beispielsweise kann die erste Messeinrichtung eine Spannungsmesseinrichtung, insbesondere zur Erfassung einer Batteriespannung, und/oder die zweite Messeinrichtung eine Strommesseinrichtung, insbesondere zur Erfassung eines Batteriestroms, insbesondere mit einem Widerstandselement sowie eine Spannungserfassungseinrichtung zur Erfassung des Spannungsabfalls über das Widerstandselement, aufweisen. Über die erste und die zweite Messeinrichtung ist somit eine konstante Erfassung der Batteriespannung und/oder des Laststroms möglich, so dass eine permanente Bestimmung des Batteriezustandes erfolgen kann. Über den dritten Eingang kann zeitgleich entweder eine Erfassung eines dritten Batterieparameters oder eine Erfassung des Kombinationssignals zur Selbstdiagnose des Batteriesensors erfolgen. Die Selbstdiagnose des Batteriesensors erfolgt also ohne Unterbrechung der Bestimmung des Batteriezustandes.

Die dritte Messeinrichtung kann einen Temperatursensor aufweisen. Die Temperatur der Batterie bzw. des Batteriesensors ändert sich üblicherweise nur sehr langsam. Die Temperaturerfassung kann somit kurzzeitig für die Selbstdiagnose des Batteriesensors unterbrochen werden.

Das Kombinationssignal kann auf beliebige Weise aus dem Prüfsignal und zumindest einem Messsignal gebildet werden. Beispielsweise erfolgt dies durch mathematische Operationen, wodurch in der Auswerteschaltung ein einfaches Herausfiltern des Prüfsignals aus dem Kombinationssignal möglich ist. Das Kombinationssignal wird beispielsweise durch Addition des Prüfsignals mit zumindest einem Messsignal gebildet, wobei das Prüfsignal und/oder das Messsignal vor der Addition verstärkt, geteilt oder anderweitig verarbeitet werden kann. Es sind aber auch andere, vorzugsweise mathematische Operationen zur Bildung des Kombinationssignals möglich. Es ist lediglich erforderlich, dass in der Auswerteschaltung aus dem Kombinationssignal ein Kontrollsignal ermittelt werden kann, dass einen Vergleich mit dem ursprünglichen Prüfsignal ermöglicht.

Beispielsweise kann das Auswertemodul einen Schalter zum Zurücksetzen des Auswertemoduls aufweisen, dessen Eingang mit der Diagnoseschaltung verbunden ist. Beispielsweise kann der Schalter das Fehlersignal empfangen und bei Empfang des Fehlersignals das Auswertemodul zurücksetzen, ausschalten und/oder neu starten. Dies kann beispielsweise von einer dem Sensor übergeordneten Steuerung als Ausfall des Batteriesensors erkannt werden, so dass eine Fehlfunktion des Batteriesensors erkannt werden kann.

Die Kombinationsschaltung kann in die Diagnoseschaltung integriert sein und insbesondere auf der gleichen Leiterplatte angeordnet sein.

Die Diagnoseschaltung kann einen Speicher für zumindest ein Prüfsignal und ein korrespondierendes Kontrollsignal aufweisen.

Vorzugsweise sind verschiedene Prüfsignale im Diagnosemodul gespeichert, wobei die Prüfsignale wechselweise an das Kombinationsmodul ausgegeben werden. Mit dem Wechsel des Prüfsignals muss sich auch das Kontrollsignal entsprechend ändern. Durch den Wechsel des Prüfsignals kann somit geprüft werden, ob das Auswertemodul bzw. die Auswerteschaltung in einem Zustand mit einem bestimmten Prüfsignal bzw. Kontrollsignal hängen geblieben ist.

Die Kombinationsschaltung, die Diagnoseschaltung und das Auswertemodul können auf einer Leiterplatte angeordnet sein.

Die Messsignale und das Prüfsignal können vor dem Bilden des Kombinationssignals zusätzlich verarbeitet werden, beispielsweise, indem diese verstärkt, geteilt oder kombiniert werden. Das Kombinationsmodul weist dazu vorzugsweise Schaltungen zum Verstärken, Teilen und/oder Kombinieren einzelner Messsignale auf.

Zur Lösung der Aufgabe ist des Weiteren ein Verfahren zur Überprüfung eines vorstehend beschriebenen Sensors vorgesehen, insbesondere eines Batteriesensors zur Bestimmung eines Batteriezustandes einer Batterie, insbesondere einer Fahrzeugbatterie. Das Verfahren weist die folgenden Schritte auf:
In einem Diagnosemodus des Sensors:
- Bilden eines Kombinationssignals aus zumindest einem Messsignal und einem Prüfsignal durch die Kombinationsschaltung,
- Empfang des zumindest einen Messsignals und dem Kombinationssignal durch das Auswertemodul,
- Ermitteln eines Kontrollsignals aus dem zumindest einen Messsignale und dem Kombinationssignal und Ausgabe des Kontrollsignals an die Diagnoseschaltung durch das Auswertemodul, und
- Abgleich des Kontrollsignals mit dem Prüfsignal und Ausgabe eines Fehlersignals, wenn eine definierte Abweichung des Kontrollsignals und des Prüfsignals festgestellt wird, durch die Diagnoseschaltung.

Vorzugsweise wird das Kombinationssignal durch Addition des zumindest einen Messsignals und des Prüfsignals gebildet.

Das Kontrollsignal wird vorzugsweise durch Herausfiltern des Prüfsignals aus dem Kombinationssignal gebildet, beispielsweise indem das Auswertemodul das von ihm gemessene Messsignal von dem Kombinationssignal wieder subtrahiert, so dass ein einfacher Vergleich des Prüfsignals und des Kontrollsignals bzw. eine einfache Erkennung von Abweichungen zwischen dem Prüfsignal und dem Kontrollsignal möglich ist.

Der Sensor kann beispielsweise zwischen dem Diagnosemodus und einem Messmodus, in dem das Auswertemodul nur ein aus den Messsignalen gebildetes Batteriezustandssignal ausgibt, umgeschaltet werden.

Im Messmodus werden mit dem Auswertemodul vorzugsweise nur Messsignale empfangen.

Weitere Vorteile und Merkmale finden sich in der nachfolgenden Beschreibung in Verbindung mit der beigefügen Zeichnung.

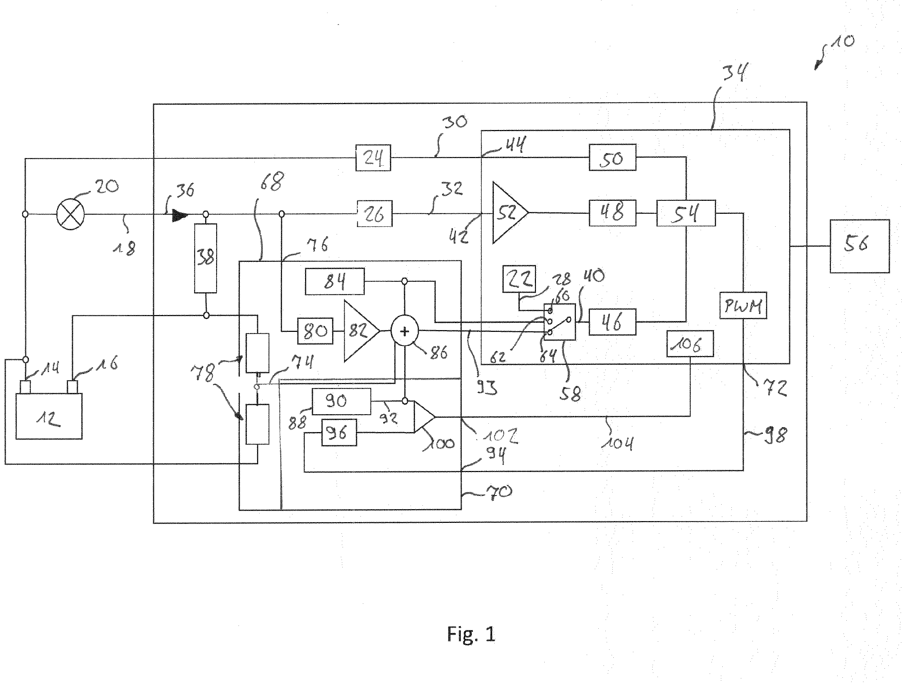

Figur 1 zeigt eine schematische Darstellung eines erfindungsgemäßen Sensors.

In Figur 1 ist ein Sensor 10, hier ein Batteriesensor zur Bestimmung eines Batteriezustandes einer Fahrzeugbatterie 12, gezeigt. Die Fahrzeugbatterie 12 hat zwei Anschlüsse 14, 16, wobei der erste Anschluss 14 dem Minuspol der Batterie entspricht und der zweite Anschluss 16 dem Pluspol der Batterie. Im Strompfad 18 zwischen den Anschlüssen 14, 16 sind elektrische Verbraucher 20 angeordnet.

Der Sensor 10 hat drei Messeinrichtungen 22, 24, 26 zur Erfassung verschiedener Batterieparameter und zur Ausgabe jeweils eines Messsignals 28, 30, 32 sowie ein Auswertemodul 34 zur Verarbeitung der Messsignale 28, 30, 32.

Die erste Messeinrichtung 22 weist einen zur Erfassung der Temperatur des Sensors ausgebildeten Temperatursensor auf. Mit der erfassten Temperatur kann beispielsweise eine Temperaturkompensation des elektrischen Widerstandes des Messwiderstandes 38 erfolgen.

Die zweite Messeinrichtung 24 ist hier eine Spannungserfassungseinrichtung zur Erfassung der Batteriespannung am zweiten Anschluss 16 der Fahrzeugbatterie 12.

Die dritte Messeinrichtung 26 ist eine Stromerfassungseinrichtung zur Erfassung des Laststroms 36 im Strompfad 18. Die dritte Messeinrichtung 24 hat hierzu einen im Strompfad 18 angeordneten Messwiderstand 38 mit bekanntem elektrischem Widerstand. Die dritte Messeinrichtung 26 kann den Spannungsabfall über den Messwiderstand 38 aufgrund des Laststroms 36 erfassen und über das ohmsche Gesetz aus dem elektrischen Widerstand des Messwiderstandes 38 und dem erfassten Spannungsabfall die Stromstärke des Laststroms 36 bestimmen.

Das Auswertemodul 34 hat drei Eingänge 40, 42, 44 für jeweils eines der Messsignale 28, 30, 32. An jedem der Eingänge 40, 42, 44 ist ein Analog-Digital-Wandler 46, 48, 50 vorgesehen, um die analogen Signale der Messeinrichtungen 22, 24, 26 in digitale Signale umzuwandeln. Am dritten Eingang 44 ist des Weiteren ein Signalverstärker 52 mit mindestens einem bekannten Verstärkungsfaktor vorgesehen.

Alternativ ist es aber auch denkbar, dass die gesamte Signalverarbeitung analog erfolgt, also keine Analog-Digital-Wandler erforderlich sind. Es ist aber auch möglich, dass die Messeinrichtungen 22, 24, 26 bereits digitale Messsignale 28, 30, 32 bereitstellen.

Auch am ersten Eingang 40 oder am zweiten Eingang 42 kann ein Signalverstärker vorgesehen sein.

Das Auswertemodul 34 hat des Weiteren eine Auswerteschaltung 54 zur Verarbeitung der Messesignale 28, 30, 32. Beispielsweise erstellt die Auswerteschaltung 54 aus den Messsignalen 28, 30, 32 ein Ausgangssignal, das den derzeitigen Batteriezustand charakterisiert und das an eine Steuerung 56 ausgegeben wird.

Am ersten Eingang 40 ist des Weiteren ein Umschalter 58 vorgesehen, der drei Signaleingänge 60, 62,64 aufweist. Am erstens Signaleingang 60 ist die erste Messeinrichtung 22 angeschlossen. Am zweiten Signaleingang 62 ist ein zweiter, externer Temperatursensor 66 angeschlossen. Am dritten Signaleingang 64 ist eine nachfolgend erläuterte Kombinationsschaltung 68 angeschlossen. Durch den Umschalter 58 kann wahlweise das Signal der ersten Messeinrichtung 22, des externen Temperatursensors 66 und der Kombinationsschaltung 68 an den ersten Eingang 40 angelegt werden.

Die Batteriespannung sowie der Laststrom können mit der zweiten Messeinrichtung 24 und der dritten Messeinrichtung 26 permanent erfasst werden. Da sich diese sehr schnell ändern können, ist für diese Batterieparameter eine ununterbrochene Erfassung erforderlich.

Die Temperatur des Sensors 10 bzw. der Batterie 12 ändert sich dagegen nur relativ langsam, so dass mit dem ersten Eingang 40 wechselweise verschiedene Signale empfangen werden können ohne die Messgenauigkeit des Sensors 10 zu beeinflussen.

Die Kombinationsschaltung 68 ist Teil einer Diagnoseschaltung 70.

Die Kombinationsschaltung 68 hat einen Eingang 74 zur Erfassung des dem zweiten Messsignal 24 ensprechenden Signals sowie einen zweiten Eingang 76 zur Erfassung des dritten Messsignals 26. Am ersten Eingang ist ein Spannungsteiler 78 vorgesehen, zur Reduzierung des zweiten Messsignals 24, also der Batteriespannung, um ein zur Spannung proportionales Signal zu erzeugen. Am zweiten Eingang 76 sind ein Filter 80 sowie ein Verstärker 82 vorgesehen, um ein der Übertragungsfunktion der Messeinrichtung 26 und des Signalverstärkers 52 proportionales Signal nachzubilden.

Des Weiteren weist die Kombinationsschaltung 68 einen zweiten Temperatursensor 84 auf, der mit dem zweiten Signaleingang 62 des Umschalters 58 verbunden ist

Der Spannungsteiler 78, der Verstärker 82 sowie der zweite Temperatursensor 84 sind mit einem Additionsmodul 86 verbunden, dass die Signale des Spannungsteilers 78, des Verstärkers 82 sowie des zweiten Temperatursensors 84 addieren kann.

Der Spannungsteiler 78, der Filter 80 sowie der Verstärker 82 sind so dimensioniert, dass die Eingangssignale am Additionsmodul 86 eine ähnliche Größe aufweisen.

Die Diagnoseschaltung 70 hat einen Speicher 88, in dem zumindest ein Referenzwert 90 gespeichert ist. Der Referenzwert 90 wird als Prüfsignal 92 an das Additionsmodul 86 ausgegeben und zu den oben genannten Eingangssignalen am Additionsmodul 86 addiert. Das Additionsmodul 86 gibt die aufsummierten Eingangssignale als Kombinationssignal 93 aus, das an den ersten Eingang 40 des Auswertemoduls 34 angelegt werden kann.

Die Diagnoseschaltung 70 weist einen Eingang 94 auf, der mit einem Ausgang 72 der Auswerteschaltung 34 verbunden ist. Die Diagnoseschaltung 70 weist des Weiteren einen Filter 96 für das am Eingang 94 anliegende Kontrollsignal 98 sowie einen Komparator 100 zum Vergleich des Kontrollsignals 98 mit dem gefilterten Prüfsignal 92 auf.

Der Sensor 10 kann in einem ersten Messmodus betrieben werden, indem der Umschalter 58 das am ersten Eingang 60 anliegende Temperatursignal des Temperatursensors 26 an die Auswerteschaltung 54 ausgibt. Die Auswerteschaltung 54 kann aus dem Temperatursignal, der mit dem zweiten Messsignal 24 empfangenen Batteriespannung sowie dem mit dem dritten Messsignal 26 empfangenen Spannungsabfall über den Messwiderstand 38 bzw. dem daraus ermittelten Laststrom den Batteriezustand der Fahrzeugbatterie 12 ermitteln.

In einem zweiten Messmodus gibt der Umschalter 58 das am zweiten Eingang 62 anliegendes Temperatursignal des zweiten Temperatursensors 84 an die Auswerteschaltung 54 aus. Auch im zweiten Messmodus kann aus diesen drei Signalen der Batteriezustand der Fahrzeugbatterie 12 ermittelt werden. Optional können bei einem direkten Umschalten zwischen dem ersten Messmodus und dem zweiten Messmodus die Temperaturen des ersten Temperatursensors 26 und des zweiten Temperatursensors 84 abgeglichen werden, um bei größeren Abweichungen eine Fehlfunktion eines der Temperatursensoren 26, 84 zu erkennen.

In einem Diagnosemodus gibt der Umschalter 58 dass am dritten Eingang 64 anliegende Kombinationssignal 93 an die Auswerteschaltung 54 aus. Da die Auswerteschaltung 54 am zweiten Eingang 30 die Batteriespannung 24 und am dritten Eingang 32 den Spannungsabfall 36 über den Messwiderstand 38 empfängt, kann die Auswerteschaltung 54 die Signale des Spannungsabfalls sowie der Batteriespannung aus dem Kombinationssignal 93 herausfiltern beispielsweise indem von einem Mittelwert des Kombinationssignals jeweils ein zu einem Mittelwert der Spannung 24 proportionaler Wert und ein zu einem Mittelwert des Spannungsabfalls 36 proportionaler Wert subtrahiert werden. Hierzu sind in der Auswerteschaltung 54 vorzugsweise das Teilungsverhältnis des Spannungsteilers 78 sowie der Verstärkungsfaktor des Verstärkers 82 gespeichert. Alternativ können diese während des Diagnosemodus von der Kombinationsschaltung 68 abgefragt werden.

Des Weiteren kann das Temperatursignal, dass sich die Temperatur nur sehr langsam ändert, aus den vorangegangenen Temperaturmessungen im ersten oder im zweiten Messmodus herausgefiltert werden.

Das um das Temperatursignal, das erste Messesignal 22 sowie das zweite Messersignal 24 reduzierte Signal wird als Kontrollsignal am Ausgang 72 an die Diagnoseschaltung 70 ausgegeben und in der Diagnoseschaltung 70 mit dem Prüfsignal 92 verglichen.

Werden aus dem Kombinationssignal 93 die Signale der Batteriespannung, des Spannungsabfalls über den Messwiderstand 36 sowie der Temperatur abgezogen, muss das Ergebnis im Normalfall dem Prüfsignal 92 entsprechen. Eine Abweichung des Prüfsignal 92 und des Kontrollsignals könnte beispielsweise auf eine Fehlfunktion an einem der Eingänge 22, 24, 26 oder des Microcontrollers 54 hindeuten.

Wird in der Diagnoseschaltung 70 eine Abweichung zwischen dem Prüfsignal und dem Kontrollsignal detektiert, wird an einem Ausgang 102 ein Fehlersignal 104 ausgegeben.

In der hier gezeigten Ausführungsform wird das Fehlersignal 104 an einen in der Auswerteschaltung 34 vorgesehenen Resetschalter 106 ausgegeben, der die Auswerteschaltung 34 zurückgesetzt oder neu startet.

Der Neustart der Auswerteschaltung 34 kann beispielsweise von einer übergeordneten Steuereinheit 108 erkannt werden und in einem Fehlerspeicher abgelegt werden.

Die Bildung des Kombinationssignals 93 sowie der Empfang und die Verarbeitung des Kombinationssignals 93 in im Auswertemodul 34 sowie der Abgleich des vom Auswertemodul 34 ausgegebenen Kontrollsignals mit dem Prüfsignal 92 ermöglichen eine Überprüfung der Funktion des Sensors 10, wobei über den ersten Eingang 28 und den zweiten Eingang 30 weiterhin eine permanente Messung der Batterieparameter und somit eine konstante Erfassung des Batteriezustandes erfolgen kann. Es wird lediglich kurzzeitig anstelle eines Temperatursignals ein Kombinationssignal an den dritten Eingang 32 angelegt, aus dem das Kontrollsignal ermittelt wird.

Somit ist eine Überprüfung des Sensors 10 möglich, ohne die Erfassung des Batteriezustandes der Fahrzeugbatterie 12 zu unterbrechen. Die Überwachung des Sensors 10 erfolgt durch eine vom Auswertemodul 34 bzw. der Auswerteschaltung 54 unabhängige Diagnoseschaltung 70.

Um den Sensor möglichst kompakt zu gestalten, können das Diagnosemodul 70, die Kombinationsschaltung 68 sowie die Auswerteschaltung 34 auf einer gemeinsamen Leiterplatte angeordnet sein.

Des Weiteren können sowohl die Auswerteschaltung 34, wie auch die Kombinationsschaltung 68 und die Diagnoseschaltung 70 Schaltungen zum Verstärken, Teilen und oder Kombinieren einzelner Messsignale oder Signale aufweisen.

In der hier gezeigten Ausführungsform erfolgt die Kombination der Messsignale und des Prüfsignal 93 durch eine Addition der Signale. Es ist aber auch möglich, das Kombinationssignal auf andere Weise zu bilden, insbesondere durch die Verwendung anderer mathematischer Operationen. Es ist lediglich erforderlich, dass aus dem Kombinationssignal 93 das ursprüngliche Prüfsignal 92 in der Auswerteschaltung 54 herausgefiltert werden kann, also die Auswerteschaltung 54 die mathematischen Operationen zur Bildung des Kombinationssignals 93 nachbilden kann.

Optional können im Diagnosemodul 70 auch mehrere verschiedene Prüfsignale 92 gespeichert sein und von diesem ausgegeben werden. In Abhängigkeit vom ausgegebenen Prüfsignal verändert sich auch das Kombinationssignal 93 sowie das Kontrollsignal. Durch die Veränderung insbesondere des Kontrollsignals kann sichergestellt werden, dass der Mikrocontroller nicht in einem Zustand mit einem festen Ausgangssignal, also einem festen Kontrollsignal, fest hängt.

Das Kontrollsignal ist vorzugsweise ein Pulsweitenmodulations-Signal (PWM-Signal). Das Kontrollsignal kann aber auch ein anderes analoges oder digitales Signal sein.

Des Weiteren können zur Bildung des Kombinationssignals verschiedene Messsignale sowie eine unterschiedliche Anzahl von Messsignalen verwendet werden. Es ist lediglich erforderlich, dass diese Messsignale sowohl der Auswerteschaltung 28 wie auch der Kombinationsschaltung 68 bereitgestellt werden.

### Bezugszeichenliste

- 10: Sensor
- 12: Fahrzeugbatterie
- 14: erster Anschluss
- 16: zweiter Anschluss
- 18: Strompfad
- 20: elektrischer Verbraucher
- 22: erste Messeinrichtung
- 24: zweite Messeinrichtung
- 26: dritte Messeinrichtung
- 28: Messsignal
- 30: Messsignal
- 32: Messsignal
- 34: Auswertemodul
- 36: Laststrom
- 38: Messwiderstand
- 40: erster Eingang
- 42: dritter Eingang
- 44: zweiter Eingang
- 46: Analog-Digital-Wandler
- 48: Analog-Digital-Wandler
- 50: Analog-Digital-Wandler
- 52: Signalverstärker
- 54: Auswerteschaltung
- 56: Steuerung
- 58: Umschalter
- 60: erster Signaleingang
- 62: zweiter Signaleingang
- 64: dritter Signaleingang (in Fig. 1 nicht vorhan-den)
- 68: Kombinationsschaltung
- 70: Diagnoseschaltung
- 72: Ausgang
- 74: erster Eingang
- 76: zweiter Eingang
- 78: Spannungsteiler
- 80: Filter
- 82: Verstärker
- 84: zweiter Temperatursensor
- 86: Additionsmodul
- 88: Speicher
- 90: Referenzwert
- 92: Prüfsignal
- 93: Kombinationssignal
- 94: Eingang
- 96: Filter
- 98: Kontrollsignal
- 100: Komparator
- 102: Ausgang
- 104: Fehlersignal
- 106: Resetschalter

## Patentansprüche

1. Sensor (10), insbesondere Batteriesensor zur Bestimmung eines Batteriezustandes einer Batterie, insbesondere einer Fahrzeugbatterie (12),
- mit zumindest zwei, jeweils zur Erfassung von Messparametern, insbesondere von Batterieparametern, und zur Ausgabe eines Messsignals (28, 30, 32) ausgebildeten Messeinrichtungen (22, 24, 26)
- mit einer Kombinationsschaltung (68), die dazu eingerichtet ist, aus zumindest einem Messsignal (28, 30, 32) und einem Prüfsignal (92) ein Kombinationssignal (93) zu bilden,
- mit einem Auswertemodul (34), das mehrere Eingänge (40, 42, 44) für Messsignale (28, 30, 32) und/oder das Kombinationssignal (93), einen Ausgang (72) für ein Kontrollsignal (98) sowie eine Auswerteschaltung (54) zur Ermittlung des Kontrollsignals (98) aus den Messsignalen (28, 30, 32) und dem Kombinationssignal (93) aufweist, und
- mit einer Diagnoseschaltung (70), zum Abgleich des Kontrollsignals (98) mit dem Prüfsignal (92) und zur Ausgabe eines Fehlersignals (104).

2. Sensor nach Anspruch 1, **dadurch gekennzeichnet, dass** ein erster Eingang (40) des Auswertemoduls (34) einen Umschalter (58) aufweist, um der erste Eingang (40) wechselweise mit zumindest einer Messeinrichtung (32,84) oder der Kombinationsschaltung (68) zu verbinden.

3. Sensor nach Anspruch 2, **dadurch gekennzeichnet, dass** eine Steuerung (56) zum Wechsel zwischen einem Diagnosemodus und einem Messmodus vorgesehen ist, wobei im Diagnosemodus der erste Eingang (40) mit der Kombinationsschaltung (68) verbunden ist und das Auswertemodul (34) zusätzlich zur Ermittlung und Ausgabe des Batteriezustandssignals das Kontrollsignal (98) ausgibt, und wobei im Messmodus das Auswertemodul (34) aus den Messsignalen (28, 30, 32) ein Batteriezustandssignal ermittelt und am Ausgang (72) ausgibt.

4. Sensor nach Anspruch 3, **dadurch gekennzeichnet, dass** im Messmodus eine erste Messeinrichtung (22) mit dem ersten Eingang (40) verbunden ist.

5. Sensor nach einem der vorhergehenden Ansprüche, **dadurch gekennzeichnet, dass** das Auswertemodul (34) drei Eingänge (40, 42, 44) aufweist, wobei ein zweiter Eingang (42) mit einer zweiten Messeinrichtung (24) und ein dritter Eingang (44) mit einer dritten Messeinrichtung (26) verbunden ist.

6. Sensor nach einem der vorhergehenden Ansprüche, **dadurch gekennzeichnet, dass** die zweite Messeinrichtung (24) eine Spannungsmesseinrichtung, insbesondere zur Erfassung einer Batteriespannung, und/oder die dritte Messeinrichtung (26) eine Strommesseinrichtung, insbesondere zur Erfassung eines Batteriestroms, insbesondere mit einem Messwiderstand (36) sowie eine Spannungserfassungseinrichtung zur Erfassung des Spannungsabfalls über den Messwiderstand (36), aufweist.

7. Sensor nach einem der vorhergehenden Ansprüche, **dadurch gekennzeichnet, dass** die erste Messeinrichtung (22) einen Temperatursensor (66) aufweist.

8. Sensor nach einem der vorhergehenden Ansprüche, **dadurch gekennzeichnet, dass** jeder Eingang (40, 42, 44) einen Analog-Digital-Wandler (46, 48, 50) aufweist.

9. Sensor nach einem der vorhergehenden Ansprüche, **dadurch gekennzeichnet, dass** das Kombinationssignal (93) durch Addition des Prüfsignals (92) mit zumindest einem Messsignal (28, 30, 32), der aus zumindest einem Messparameter ermittelt wird, gebildet wird.

10. Sensor nach einem der vorhergehenden Ansprüche, **dadurch gekennzeichnet, dass** das Auswertemodul (34) einen Resetschalter (106) aufweist, dessen Eingang mit der Diagnoseschaltung (70) verbunden ist.

11. Sensor nach einem der vorhergehenden Ansprüche, **dadurch gekennzeichnet, dass** die Kombinationsschaltung (68) in die Diagnoseschaltung (70) integriert ist.

12. Sensor nach einem der vorhergehenden Ansprüche, **dadurch gekennzeichnet, dass** die Diagnoseschaltung (70) einen Speicher (88) für zumindest ein Prüfsignal (92) aufweist.

13. Sensor nach einem der vorhergehenden Ansprüche, **dadurch gekennzeichnet, dass** die Kombinationsschaltung (68), die Diagnoseschaltung (70) und das Auswertemodul (34) auf einer Leiterplatte angeordnet sind.

14. Sensor nach einem der vorhergehenden Ansprüche, **dadurch gekennzeichnet, dass** die Kombinationsschaltung (68) Schaltungen zum Verstärken, Teilen und/oder Kombinieren einzelner Messsignale (28, 30, 32) aufweist.

15. Verfahren zur Überprüfung eines Sensors (10), insbesondere eines Batteriesensors zur Bestimmung eines Batteriezustandes einer Batterie, insbesondere einer Fahrzeugbatterie (12), nach einem der vorhergehenden Ansprüche, mit folgenden Schritten:
In einem Diagnosemodus des Sensors (10)
- Bilden eines Kombinationssignals (93) aus zumindest einem Messsignal (28, 30, 32) und einem Prüfsignal (92)
- Empfang von zumindest zwei Messsignalen (28, 30, 32) und dem Kombinationssignal (93) durch das Auswertemodul (34),
- Ermitteln eines Kontrollsignals (98) aus den Messsignalen (28, 30, 32) und dem Kombinationssignal (98) durch das Auswertemodul (34) und Ausgabe des Kontrollsignals (98) an die Diagnoseschaltung (70),
- Abgleich des Kontrollsignals (98) mit dem Prüfsignal (92) und Ausgabe eines Fehlersignals (104), wenn eine definierte Abweichung des Kontrollsignals (98) und des Prüfsignals (92) festgestellt wird.

16. Verfahren nach Anspruch 15, **dadurch gekennzeichnet, dass** das Kombinationssignal (98) zumindest durch eine mathematische Operation, insbesondere Addition des zumindest einen Messsignals (28, 30, 32) und des Prüfsignals (92) gebildet wird.

17. Verfahren nach einem der Ansprüche 15 und 16, **dadurch gekennzeichnet, dass** das Kontrollsignal (98) durch Herausfiltern oder der mathematischen Umkehroperation des Prüfsignals (92) aus dem Kombinationssignal (93) gebildet wird.

18. Verfahren nach einem der Ansprüche 15 bis 17, **dadurch gekennzeichnet, dass** der Sensor (10) zwischen dem Diagnosemodus und einem Messmodus, in dem das Auswertemodul (34) ein aus den Messsignalen (28, 30, 32) gebildetes Batteriezustandssignal ausgibt, umgeschaltet wird.

19. Verfahren nach Anspruch 18, **dadurch gekennzeichnet, dass** im Messmodus mit dem Auswertemodul ausschließlich Messsignale (28, 30, 32) empfangen werden.

## Claims

1. Sensor (10), in particular battery sensor for determining a battery state of a battery, in particular of a vehicle battery (12),
- comprising at least two measurement apparatuses (22, 24, 26) that are each designed to record measurement parameters, in particular battery parameters, and to output a measurement signal (28, 30, 32),
- comprising a combination circuit (68) that is configured to form a combination signal (93) from at least one measurement signal (28, 30, 32) and one test signal (92),
- comprising an evaluation module (34) that has multiple inputs (40, 42, 44) for measurement signals (28, 30, 32) and/or the combination signal (93), an output (72) for a control signal (98) and an evaluation circuit (54) for ascertaining the control signal (98) from the measurement signals (28, 30, 32) and the combination signal (93), and
- comprising a diagnostic circuit (70) for comparing the control signal (98) with the test signal (92) and for outputting an error signal (104).

2. Sensor according to Claim 1, **characterized in that** a first input (40) of the evaluation module (34) has a changeover switch (58) in order to connect the first input (40) selectively to at least one measurement apparatus (32, 84) or the combination circuit (68).

3. Sensor according to Claim 2, **characterized in that** a controller (56) is provided to change between a diagnostic mode and a measurement mode, wherein, in the diagnostic mode, the first input (40) is connected to the combination circuit (68) and the evaluation module (34) outputs the control signal (98) in addition to ascertaining and outputting the battery state signal, and wherein, in the measurement mode, the evaluation module (34) ascertains a battery state signal from the measurement signals (28, 30, 32) and outputs it at the output (72).

4. Sensor according to Claim 3, **characterized in that**, in the measurement mode, a first measurement apparatus (22) is connected to the first input (40).

5. Sensor according to one of the preceding claims, **characterized in that** the evaluation module (34) has three inputs (40, 42, 44), wherein a second input (42) is connected to a second measurement apparatus (24) and a third input (44) is connected to a third measurement apparatus (26).

6. Sensor according to one of the preceding claims, **characterized in that** the second measurement apparatus (24) has a voltage measurement apparatus, in particular for recording a battery voltage, and/or the third measurement apparatus (26) has a current measurement apparatus, in particular for recording a battery current, in particular comprising a measuring resistor (36), and a voltage recording apparatus for recording the voltage drop across the measuring resistor (36).

7. Sensor according to one of the preceding claims, **characterized in that** the first measurement apparatus (22) has a temperature sensor (66).

8. Sensor according to one of the preceding claims, **characterized in that** each input (40, 42, 44) has an analogue-to-digital converter (46, 48, 50).

9. Sensor according to one of the preceding claims, **characterized in that** the combination signal (93) is formed by addition of the test signal (92) to at least one measurement signal (28, 30, 32) that is ascertained from at least one measurement parameter.

10. Sensor according to one of the preceding claims, **characterized in that** the evaluation module (34) has a reset switch (106), the input of which is connected to the diagnostic circuit (70).

11. Sensor according to one of the preceding claims, **characterized in that** the combination circuit (68) is integrated in the diagnostic circuit (70).

12. Sensor according to one of the preceding claims, **characterized in that** the diagnostic circuit (70) has a memory (88) for at least one test signal (92).

13. Sensor according to one of the preceding claims, **characterized in that** the combination circuit (68), the diagnostic circuit (70) and the evaluation module (34) are arranged on a printed circuit board.

14. Sensor according to one of the preceding claims, **characterized in that** the combination circuit (68) has circuits for amplifying, dividing and/or combining individual measurement signals (28, 30, 32).

15. Method for checking a sensor (10), in particular a battery sensor for determining a battery state of a battery, in particular of a vehicle battery (12), according to one of the preceding claims, comprising the following steps:
in a diagnostic mode of the sensor (10),
- forming a combination signal (93) from at least one measurement signal (28, 30, 32) and one test signal (92),
- receiving at least two measurement signals (28, 30, 32) and the combination signal (93) by way of the evaluation module (34),
- ascertaining a control signal (98) from the measurement signals (28, 30, 32) and the combination signal (98) by way of the evaluation module (34) and outputting the control signal (98) to the diagnostic circuit (70),
- comparing the control signal (98) with the test signal (92) and outputting an error signal (104) if a defined variance between the control signal (98) and the test signal (92) is identified.

16. Method according to Claim 15, **characterized in that** the combination signal (98) is formed at least by a mathematical operation, in particular addition of the at least one measurement signal (28, 30, 32) and the test signal (92).

17. Method according to either of Claims 15 and 16, **characterized in that** the control signal (98) is formed by filtering, or the inverse mathematical operation, the test signal (92) from the combination signal (93).

18. Method according to one of Claims 15 to 17, **characterized in that** the sensor (10) is changed over between the diagnostic mode and a measurement mode, in which the evaluation module (34) outputs a battery state signal formed from the measurement signals (28, 30, 32).

19. Method according to Claim 18, **characterized in that**, in the measurement mode, exclusively measurement signals (28, 30, 32) are received by the evaluation module.

## Revendications

1. Capteur (10), en particulier capteur de batterie pour déterminer un état de batterie d'une batterie, en particulier d'une batterie de véhicule (12),
- avec au moins deux dispositifs de mesure (22, 24, 26) conçus chacun pour la saisie de paramètres de mesure, en particulier de paramètres de batterie, et pour l'émission d'un signal de mesure (28, 30, 32),
- avec un circuit de combinaison (68) qui est conçu pour former un signal de combinaison (93) à partir d'au moins un signal de mesure (28, 30, 32) et d'un signal de vérification (92),
- avec un module d'évaluation (34) qui présente plusieurs entrées (40, 42, 44) pour les signaux de mesure (28, 30, 32) et/ou le signal de combinaison (93), une sortie (72) pour un signal de contrôle (98) ainsi qu'un circuit d'évaluation (54) pour déterminer le signal de contrôle (98) à partir des signaux de mesure (28, 30, 32) et du signal de combinaison (93), et
- avec un circuit de diagnostic (70), pour comparer le signal de contrôle (98) avec le signal de vérification (92) et pour émettre un signal d'erreur (104).

2. Capteur selon la revendication 1, **caractérisé en ce qu'**une première entrée (40) du module d'évaluation (34) comprend un commutateur (58) pour relier alternativement la première entrée (40) à au moins un dispositif de mesure (32, 84) ou au circuit de combinaison (68).

3. Capteur selon la revendication 2, **caractérisé en ce qu'**il est prévu une commande (56) pour passer d'un mode de diagnostic à un mode de mesure, la première entrée (40) étant reliée au circuit combiné (68) en mode diagnostic et le module d'évaluation (34) émettant le signal de contrôle (98) en plus de la détermination et de l'émission du signal d'état de la batterie, et le module d'évaluation (34) déterminant un signal d'état de la batterie à partir des signaux de mesure (28, 30, 32) et l'émettant à la sortie (72) en mode de mesure.

4. Capteur selon la revendication 3, **caractérisé en ce qu'**en mode de mesure, un premier dispositif de mesure (22) est relié à la première entrée (40).

5. Capteur selon l'une des revendications précédentes, **caractérisé en ce que** le module d'évaluation (34) présente trois entrées (40, 42, 44), une deuxième entrée (42) étant reliée à un deuxième dispositif de mesure (24) et une troisième entrée (44) à un troisième dispositif de mesure (26).

6. Capteur selon l'une des revendications précédentes, **caractérisé en ce que** le deuxième dispositif de mesure (24) comprend un dispositif de mesure de tension, notamment pour détecter une tension de batterie, et/ou le troisième dispositif de mesure (26) comprend un dispositif de mesure de courant, notamment pour détecter un courant de batterie, notamment avec une résistance de mesure (36) ainsi qu'un dispositif de détection de tension pour détecter la chute de tension aux bornes de la résistance de mesure (36).

7. Capteur selon l'une des revendications précédentes, **caractérisé en ce que** le premier dispositif de mesure (22) comprend un capteur de température (66).

8. Capteur selon l'une des revendications précédentes, **caractérisé en ce que** chaque entrée (40, 42, 44) comprend un convertisseur analogique-numérique (46, 48, 50).

9. Capteur selon l'une des revendications précédentes, **caractérisé en ce que** le signal combiné (93) est formé par addition du signal de vérification (92) avec au moins un signal de mesure (28, 30, 32) déterminé à partir d'au moins un paramètre de mesure.

10. Capteur selon l'une des revendications précédentes, **caractérisé en ce que** le module d'évaluation (34) comprend un commutateur de réinitialisation (106) dont l'entrée est reliée au circuit de diagnostic (70).

11. Capteur selon l'une des revendications précédentes, **caractérisé en ce que** le circuit de combinaison (68) est intégré dans le circuit de diagnostic (70).

12. Capteur selon l'une des revendications précédentes, **caractérisé en ce que** le circuit de diagnostic (70) comprend une mémoire (88) pour au moins un signal de vérification (92).

13. Capteur selon l'une des revendications précédentes, **caractérisé en ce que** le circuit combiné (68), le circuit de diagnostic (70) et le module d'évaluation (34) sont disposés sur une carte à circuit imprimé.

14. Capteur selon l'une des revendications précédentes, **caractérisé en ce que** le circuit de combinaison (68) comprend des circuits d'amplification, de division et/ou de combinaison de signaux de mesure individuels (28, 30, 32).

15. Procédé de contrôle d'un capteur (10), notamment d'un capteur de batterie pour déterminer un état de batterie d'une batterie, notamment d'une batterie de véhicule (12), selon l'une des revendications précédentes, comprenant les étapes suivantes :
dans un mode de diagnostic du capteur (10),
- formation d'un signal de combinaison (93) à partir d'au moins un signal de mesure (28, 30, 32) et d'un signal de vérification (92),
- réception d'au moins deux signaux de mesure (28, 30, 32) et du signal combiné (93) par le module d'évaluation (34),
- détermination d'un signal de contrôle (98) à partir des signaux de mesure (28, 30, 32) et du signal combiné (98) par le module d'évaluation (34) et émission du signal de contrôle (98) vers le circuit de diagnostic (70),
- comparaison du signal de contrôle (98) avec le signal de vérification (92) et émission d'un signal d'erreur (104) lorsqu'un écart défini entre le signal de contrôle (98) et le signal de vérification (92) est constaté.

16. Procédé selon la revendication 15, **caractérisé en ce que** le signal de combinaison (98) est formé au moins par une opération mathématique, en particulier par addition dudit au moins un signal de mesure (28, 30, 32) et du signal de vérification (92).

17. Procédé selon l'une des revendications 15 et 16, **caractérisé en ce que** le signal de contrôle (98) est formé par filtrage ou par l'opération mathématique d'inversion du signal de vérification (92) à partir du signal combiné (93).

18. Procédé selon l'une des revendications 15 à 17, **caractérisé en ce que** le capteur (10) est commuté entre le mode diagnostic et un mode de mesure dans lequel le module d'évaluation (34) délivre un signal d'état de batterie formé à partir des signaux de mesure (28, 30, 32).

19. Procédé selon la revendication 18, **caractérisé en ce qu'**en mode de mesure, le module d'évaluation reçoit exclusivement des signaux de mesure (28, 30, 32).
